# EUROPÄISCHE PATENTANMELDUNG

(11) **EP 0 812 006 A1**
(43) Veröffentlichungstag der Anmeldung: **10.12.1997**
(21) Anmeldenummer: 96114122.3
(22) Anmeldetag: 04.09.1996
(51) Int. Cl.: H01L 21/00

(54) **Werkzeug zum Anbringen elektrischer Anschlusskontakte auf Halbleiterbauelementen**

(30) Priorität: 07.06.1996 DE 19622798; 02.09.1996 DE 9634953 U
(71) Anmelder: Deutsches Elektronen-Synchrotron DESY, 22607 Hamburg (DE)
(72) Erfinder: Teske,Artur, 21629 Neu Wulmstorf (DE)
(74) Vertreter: Niedmers, Ole, Dipl.-Phys.

(57) **Zusammenfassung**

Es wird ein Werkzeug zum Anbringen elektrischer Anschlußkontakte auf Halbleiterbauelementen oder zur Ausbildung elektrischer Verbindungen elektrischer Schaltkreise in Hybridschaltungen vorgeschlagen, umfassend einen in einem Halter (11) einer Vorrichtung (12) eingespannten stabförmigen, metallischen oder hartmetallischen oder aus Hartstoff bestehenden Körper (13), mit dem ein den Anschluß oder die Verbindung herstellender Draht (15) auf eine Kontaktstelle des Bauelementes oder der Schaltung gepreßt wird, wobei nachfolgend mittels Schweißung der Draht (15) mit der Kontaktstelle metallisch verbunden wird. Der Körper (13) wird dabei wenigstens teilweise in einem Hülsenelement (14) haltend aufgenommen, wobei der Körper (13) über das Hülsenelement (14) im Halter (11) eingespannt wird.

## Beschreibung

Die Erfindung betrifft ein Werkzeug zum Anbringen elektrischer Anschlußkontakte auf Halbleiterbauelementen oder zur Ausbildung elektrischer Verbindungen elektrischer Schaltkreise in Hybridschaltungen, umfassend einen in einem Halter einer Vorrichtung eingespannten stabförmigen, metallischen oder hartmetallischen oder aus Hartstoff bestehenden Körper, mit dem ein den Anschluß oder die Verbindung herstellender Draht auf eine Kontaktstelle des Bauelementes oder der Schaltung gepreßt wird, wobei nachfolgend mittels Schweißung der Draht mit der Kontaktstelle metallisch verbunden wird

Werkzeuge dieser Art werden seit langem in der Halbleiterindustrie eingesetzt, um beispielsweise elektrische Anschlußkontakte auf Halbleiterbauelementen herzustellen oder aber elektrische Verbindungen zwischen elektrischen Schaltkreisen wie Hybridschaltungen oder sogenannten Multichipmodulen auszubilden. Werkzeuge dieser Art werden dafür in Vorrichtungen eingesetzt, die in vollautomatischem Betrieb mit hoher Geschwindigkeit derartige Kontaktverbindungen herstellen. Derartige Verfahren zum Anbringen elektrischer Anschlußkontakte werden auch Bonden genannt, wobei die eigentliche Verbindung zwischen dem zugeführten Draht und der Kontaktstelle auf dem Halbleiterelement, der Hybridschaltung oder bei Multichipmodulen beispielsweise durch Thermokompressionsschweißen oder Ultraschallschweißen hergestellt wird.

Das eigentliche Werkzeug in einer derartigen automatischen Bondvorrichtung ist ein stabförmiger Körper, der an seinem der herzustellenden Kontaktverbindung zugewandtem Ende eine rechteckige Fläche aufweist, die beispielsweise 20 * 30 µm groß ist. Der Körper wird mit dieser Spitze beim Anbringen der Drähte an der Kontaktstelle unter Zwischenlage des geeignet zugeführten Drahtes, der den Anschlußkontakt bzw. die Verbindung bilden soll, mit hohem Druck auf die Kontaktstelle bzw. den Draht gedrückt, wobei in Druckstellung der eigentliche Schweißvorgang, beispielsweise mittels Ultraschallschweißung, ausgeführt wird, so daß am Ende der Draht mit der Kontaktstelle metallisch verbunden ist.

Der das eigentliche Werkzeug im wesentlichen ausmachende Körper besteht beispielsweise aus Wolframcarbid, wodurch eine hohe Belastbarkeit und Standzeit des das Werkzeug im wesentlichen ausmachenden Körpers erreicht wird.

Der Druck, den der Körper des Werkzeugs auf den Draht, wenn dieser auf die Kontaktstelle gedrückt wird, ausübt, ist so groß, daß der Draht regelrecht plattgedrückt wird, wobei bei bisherigen Werkzeugen dieser Art bei diesem Andrückvorgang beobachtet wird, daß der Draht durch diese spanlose Verformung geschwächt wird, d.h. vorprogrammierte Bruchstellen erzeugt werden, die eine erhebliche mechanische Schwächung der Verbindung und somit auch eine Gefährdung der Sicherheit der elektrischen Verbindung zur Folge haben. Der sehr hohe Druck beim Andrückvorgang des Drahtes an die Kontaktstelle mittels des das Werkzeug im wesentlichen bildenden Körpers ist bisher deshalb erforderlich, weil die Halterung des metallischen oder aus Hartstoff bestehenden Körpers im Halter der Vorrichtung ungenügend präzise ist, wobei man bisher versuchte, diesen Nachteil dadurch auszugleichen, daß man den Andruck des Körpers mit seiner aktiven Spitze an den Draht bzw. die Kontaktstelle noch höher wählte, was wiederum zu den voraufgeführten erheblichen Nachteilen in bezug auf die mechanische und elektrische Verbindung des Drahtes mit der Kontaktstelle führte. Ein weiterer Nachteil des bisherigen Werkzeugs besteht darin, daß aufgrund des zwingend erforderlichen hoch auszubildenden Druckes verhältnismäßig viel Zeit erforderlich ist, um die Verbindung zwischen Draht und Kontaktstelle herzustellen.

Es ist somit Aufgabe der vorliegenden Erfindung, ein Werkzeug der eingangs genannten Art zu schaffen, mit dem die Ausbildung mechanisch und elektrisch zuverlässigerer Verbindungen zwischen Draht und Kontaktstelle möglich ist als es bisher bei bekannten Vorrichtungen möglich war, mit dem für die eigentliche Ausbildung der metallischen Verbindung zwischen Draht und Kontaktstelle geringere Schweißenergien erforderlich sind als bisher und mit dem gegenüber bisherigen Werkzeugen dieser Art weniger Zeit zur Ausbildung der metallischen Verbindung zwischen Kontaktstelle und Draht erforderlich ist, so daß automatisierte Verbindungsvorgänge mit dem Werkzeug gegenüber bisherigen Werkzeugen dieser Ort in der Geschwindigkeit beträchtlich gesteigert werden können.

Gelöst wird die Aufgabe gemäß der Erfindung dadurch, daß der Körper wenigstens teilweise in einem Hülsenelement haltend aufgenommen wird, wobei der Körper über das Hülsenelement im Halter eingespannt wird.

Der Vorteil der erfindungsgemäßen Lösung besteht im wesentlichen darin, daß aufgrund des mit sehr viel höherer Präzision im Durchmesser ausbildbaren Hülsenschaftes dieser mit hoher Präzision und mit hoher Festigkeit senkrecht im Halter der Vorrichtung eingespannt werden kann, wobei auch über lange Arbeitszeiträume mit dem Werkzeug in der Vorrichtung keine Veränderung des Sitzes des Werkzeugs im Halter der Vorrichtung beobachtet wird. Dadurch wird erreicht, daß die eigentliche Kontakt- oder Arbeitsfläche des das Werkzeug im wesentlichen bildenden Körpers immer hochgenau parallel zur Oberfläche der Kontaktstelle aufgesetzt wird. Aufgrund der hochpräzison Halterung des Körpers über das Hülsenelement im Halter kann die Andruckkraft, mit der der Körper mit seiner Spitze auf den Draht und dieser auf die Kontaktstelle gehalten wird, beträchtlich geringer gehalten werden als bei bisherigen Werkzeugen dieser Art, so daß Schwächungen und Bruchstellen nicht entstehen, mit der Folge, daß die hergestellte Verbindung, wie angestrebt, eine weitaus höhere mechanische Stabilität aufweist und Herstellungsmängel wie fehlerhafte Kontaktierung und sogar Bruch vermieden werden. Dieses ist insbesondere auch wichtig und vorteilhaft bei der Ausbildung von Verbindungen an sich bruchempfindlicher Halbleiter, beispielsweise GaAs-Halbleiter. Da mit dem erfindungsgemäßen Werkzeug sehr viel weniger Druck für die Ausbildung der Verbindung zwischen Draht und Kontaktstelle benötigt wird, kann der einzelne Vorgang zur Ausbildung der metallischen Verbindung zwischen Kontaktstelle und Draht in der Zeit beträchtlich reduziert werden, beispielsweise im Bereich von 10 bis 15 % weniger Zeit pro Verbindungsvorgang als bisher.

Man hat errechnet, daß beim Vorsehen des erfindungsgemäßen Werkzeugs in automatischen Bondvorrichtungen beispielsweise ein Zeitgewinn von 30 Minuten pro Schicht erwartet werden kann.

Grundsätzlich kann das Hülsenelement vorzugsweise aus einem beliebigen metallischen oder hartmetallischen Werkstoff oder Hartstoff hergestellt werden, wobei allerdings sichergestellt sein muß, daß beispielsweise der Hülsenschaft, über den der Verbund aus Hülsenelement und Körper im Halter der Vorrichtung eingespannt wird, mit hoher Präzision herstellbar ist bzw. hergestellt wird, beispielsweise mit einer Toleranz im Bereich von 50 µm im Durchmesser.

Als besonders vorteilhaft hat sich für die Ausbildung des Hülsenelementes Messing erwiesen, das verhältnismäßig einfach bearbeitbar ist und auch bei langen Standzeiten des Werkzeugs sich in hohem Maße formstabil verhält.

Der Körper und das Hülsenelement, das zur Aufnahme des Körpers ein einseitig offenes Sackloch aufweist, werden vorzugsweise im Hülsenelement mittels einer Klebeverbindung miteinander verbunden, die eine garantiert formfest ausgebildete Stellung des Körpers innerhalb des Hülsenelements sicherstellt, und zwar auch lange Standzeiten gewährleistet und den typischerweise auftretenden Drücken, mit den das Werkzeug auf den Draht bzw. die Kontaktstelle gedrückt wird, fortwährend standhält.

Prinzipiell ist dafür jeder geeignete Kleber verwendbar, der die voraufgeführten Bedingungen erfüllt. Es hat sich jedoch als vorteilhaft erwiesen, dafür insbesondere Epoxidharz zu verwenden, da Epoxidharz eine einfache Handhabbarkeit bei der Ausbildung der Klebeverbindung zwischen Körper und Hülsenelement gestattet.

Um beispielsweise bisherige Körper aus Wolframcarbid, aber auch aus anderen dafür geeigneten Werkstoffen hergestellte Werkzeuge, d.h. grundsätzlich schon verwendete Werkzeuge nachträglich auch in Halter von Bondvorrichtungen einsetzen zu können, die an sich für bisherige Körperdurchmesser ausgelegt sind, ist es vorteilhaft, daß das zum Halter gerichtete Element des Hülsenelementes verjüngt ausgebildet ist, und zwar entsprechend dem Durchmesser bisheriger bekannter Körper, so daß nachträglich der Körper, entsprechend der Hülsengeometrie gekürzt, an die Stelle bisheriger Werkzeuge in schon bestehenden Bondvorrichtungen gesetzt bzw. dort haltend aufgenommen werden kann.

Um die Spannsicherheit bzw. die Haltesicherheit an sich in der Bondvorrichtung des aus Hülsenelement und darin aufgenommenen Körper bestehenden Werkzeugs zu erhöhen, weist das Hülsenelement vorzugsweise eine abgeplattete Spannfläche, im wesentlichen parallel zur Längsachse des Werkzeugs, auf, wobei dann, wenn das Hülsenelement, wie vorangehend beschrieben, ein verjüngtes Ende aufweist, dieses vorzugsweise am verjüngten Ende die abgeplattete Spannfläche vorgesehen ist.

Vorteilhafterweise wird das Hülsenelement durch eine auf den Körper aufbringbare Beschichtung gebildet, beispielsweise mittels der bekannten PVD- oder CVD-Verfahren, die einen gezielten Aufbau der Beschichtung sowohl in bezug auf ihre physikalisch-chemische Struktur als auch ihre mechanischen Eigenschaften und ihre geometrische Struktur ermöglichen.

Für bestimmte Anwendungsfälle kann es sinnvoll sein, daß das Hülsenelement und der Körper einstückig ausgebildet sind, was zu einer leichteren Bearbeitbarkeit und zu einer Verminderung der Fertigungskosten des Werkzeugs führen kann.

Sowohl bei dem auf vorangehende Weise aufgebauten Werkzeug mit integraler Ausbildung von Hülsenelement- und körper als auch bei der Ausbildung von gesondert ausgebildetem Hülsenelement und gesondert ausgebildetem Körper ist es vorteilhaft, zur Erhöhung der Standzeit des Werkzeugs wenigstens die Andruckspitze des Körpers, d. h. die Spitze, mit der der Verbindungsdraht an die entsprechende Stelle des Halbleiterbauelementes oder der Hybridschaltung zur Ausbildung einer Verbindung gedrückt wird, mit einer Beschichtung zu versehen. Diese Beschichtung wird vorteilhafterweise so gewählt, daß sie gegenüber dem Werkstoff der Andruckspitze zur Ausführung des Verbindungsvorganges geeignetere physikalische Eigenschaften als eine unbeschichtete Andruckspitze des Werkzeugs aufweist, wobei bessere physikalische Eigenschaften bedeutet, daß dadurch die Präzision des Andrucks der Andruckspitze an den Draht gegenüber unbeschichteten Andruckspitzen verbessert wird und die eigentliche Verbindung noch sicherer ausgebildet werden kann.

Als Beschichtung eignet sich vorteilhafterweise Metall oder Hartmetall oder auch Hartstoff, wobei sich als Hartmetall insbesondere Titan und Titanlegierungen wie Titan-Hafnium oder Titan-Zirkonium eignen, wohingegen als Hartstoff insbesondere Titannitrid oder Titancarbid oder Titan-Hafnium - bzw. Titan-Zirkonium-Nitrid bzw. Carbid geeignet ist.

Die Beschichtung kann aber auch vorteilhafterweise aus Kohlenstoff, beispielweise Diamant bestehen.

Die Erfindung wird nun unter Bezugnahme auf die beiliegenden schematischen Zeichnungen anhand eines Ausführungsbeispieles im einzelnen beschrieben. Darin zeigen:
- Fig. 1: in der Seitenansicht einen Ausschnitt aus einer Bondvorrichtung, bei der das erfindungsgemäße Werkzeug an der Spitze eines Halters eingespannt befestigt ist,
- Fig. 2: in teilweisem Schnitt einen Ausschnitt aus dem erfindungsgemäßen Werkzeug, bestehend aus Hülsenelement und Körper,
- Fig. 3: eine Seitenansicht des Werkzeugs, bestehend aus Hülsenelement und Körper,
- Fig. 4: eine Ansicht auf das Werkzeug gemäß Fig. 3, jedoch um 90° um die Längsachse des Werkzeugs gedreht,
- Fig. 5: eine Seitenansicht des Werkzeugs, bei dem das Hülsenelement und der Körper einstückig ausgebildet sind, wobei das Ende des Körpers gegenüber dem übrigen Körper verjüngt ausgebildet ist,
- Fig. 6: eine Ansicht auf das Werkzeug gemäß Fig. 5, jedoch um 90° um die Längsachse des Werkzeugs gedreht,
- Fig. 7: eine Seitenansicht des Werkzeugs, bei dem das Hülsenelement und der Körper einstückig ausgebildet sind, wobei aber das Ende des Körpers und der übrige Teil des Körpers eine im wesentlichen gleiche Querschnittsabmessung aufweisen, und
- Fig. 8: eine Ansicht auf das Werkzeug gemäß Fig. 7, jedoch um 90° um die Längsachse des Werkzeugs gedreht.

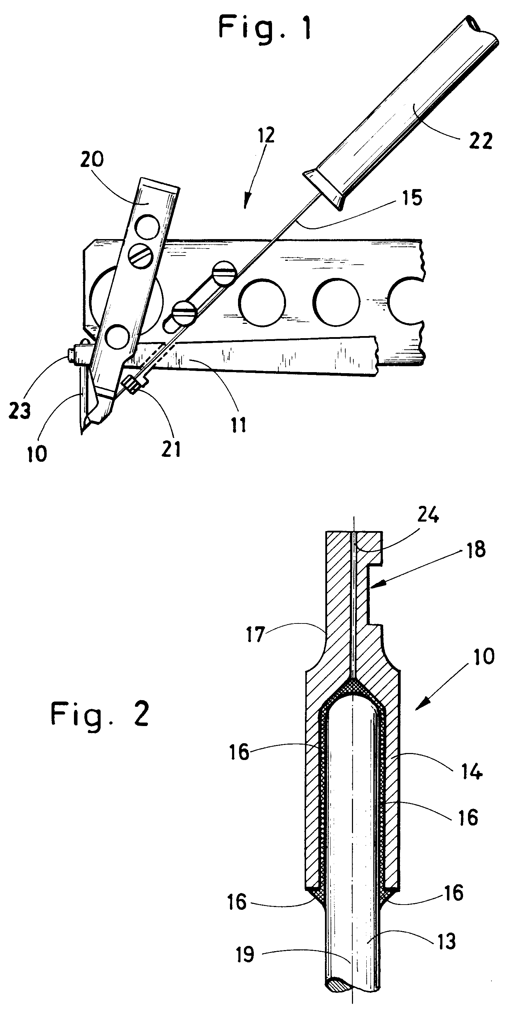

Das Werkzeug 10 zum Anbringen elektrischer Anschlußkontakte auf Halbleiterelementen oder zur Ausbildung elektrischer Verbindungen elektrischer Schaltkreise in Hybridschaltungen wird in einer Vorrichtung 12 verwendet, wie sie im Ausschnitt schematisch in Fig. 1 dargestellt ist. Zum besseren Verständnis des eigentlichen Werkzeuges 10 wird deshalb kurz auf die an sich in bezug auf ihren Ausbau und ihre Funktion bekannte Vorrichtung 12 eingegangen.

Über eine Drahtzuführung 22 wird Draht 1, der den Anschlußkontakt bzw. die elektrische Verbindung bilden soll, über eine Spannklammer 21, die dafür sorgt, daß der Draht 15 gestreckt bleibt, auf eine Drahtklammer 20 geführt und von dort an die Spitze des eigentlichen Werkzeugs 10. Das Werkzeug 10 wird in einem Halter 11 derart gehalten, daß der Draht 15 dann parallel zu einer hier nicht dargestellten Kontaktstelle eines Halbleiterbauelements oder eine Hybridschaltung und dergleichen durch Andruck mittels der Spitze des Werkzeugs 10 gehalten wird, wenn der eigentliche Verbindungsvorgang des Drahtes 15 mit der Kontaktstelle beispielsweise durch einen Ultraschweißvorgang hergestellt wird. Das setzt voraus, daß das Werkzeug 10 mit hohem Druck in diesem Zeitpunkt mit seiner in Fig. 1 nicht dargestellten, im wesentlichen rechteckigen Andruckoberfläche, die beispielsweise eine Größe von 20 * 30 µm aufweist, parallel zur Kontaktoberfläche gehalten wird. Aus diesem Grunde ist das Werkzeug 10 im hin- und herschwenkbaren Halter 11 mit hoher Präzision zu halten, und zwar über extrem lange Arbeitszyklen, damit ein Nachjustieren oder ein erneutes Befestigen, was für einen geordneten Fertigungsvorgang absolut inakzeptabel wäre, vermieden wird. Das Werkzeug 10 ist über ein lösbares Befestigungsmittel 23 im Halter 11 befestigt.

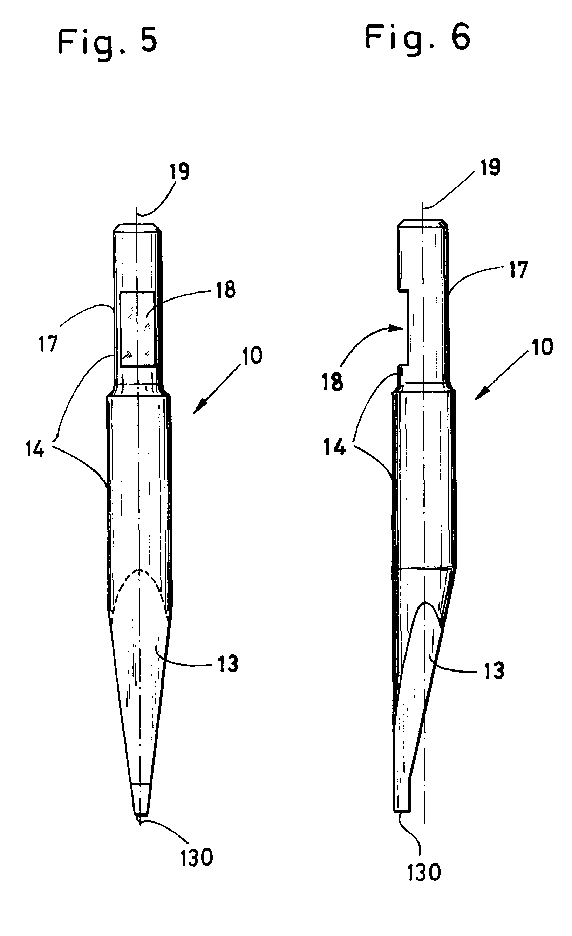

Bezüglich des Aufbaus des Werkzeugs 10 wird zunächst auf Fig. 2 verwiesen. Das Werkzeug 10 besteht im wesentlichen aus einem zylindrischen, zu seiner Arbeitsspitze hin angespitzten Körper 13, wobei die Ausdruckspitze des Körpers 13, vergleiche Fig. 5 bis 8, eine Andruckfläche von beispielsweise 20 * 30 µm, siehe auch oben, aufweist, mit der der Draht 15 auf die hier nicht dargestellt Kontaktstelle des Halbleiterbauelements oder dergleichen aufgedrückt und während des Schweißvorganges unter Druck gegengehalten wird.

Der Körper 13 besteht aus Metall, Hartmetall oder Hartstoff, beispielsweise aus Wolframcarbid. Der zylindrische Körper 13 wird von einem im wesentlichen ebenfalls zylindrischen Hülsenelement 14, das ein zylindrisches Sackloch aufweist, im Sackloch aufgenommen, wobei der Körper 13 mit dem Hülsenelement 14 mittels einer Klebeverbindung 16, beispielsweise aus Epoxidharz, verbunden ist. Das Hülsenelement 14 weist ein Durchgangsloch 24 auf, das den Innenraum des Sackloches für den Körper 13 mit dem Äußeren des Hülsenelements 14 verbindet, so daß beim Einsetzen des Körpers 13 das Hülsenelement 14 unter Aufbringung des erwähnten Klebers eingeschlossene Luft aus dem Sackloch des Hülsenelements 14 beim Einschieben des Körpers 13 entweichen kann.

Das Hülsenelement 14 weist an seinem zum Halter 11 gerichteten Ende 17 eine zylindrische Verjüngung auf, so daß es mit diesem Bereich in den Halter 11 eingesetzt werden kann, und zwar auch in Halter 11, die bisher lediglich für die Aufnahme der im Stand der Technik bekannten Werkzeuge 10, die nur aus einem Körper 13 bestanden, ausgebildet waren. Zur Erhöhung der Haltesicherheit des Werkzeugs 10 im Halter 11 ist am zum Halter gerichteten Ende des Hülsenelements 14 eine abgeplattete Spannfläche 18 ausgebildet, an die sich mit guter Auflage ein Befestigungsmittel 23 zur Sicherung einer fortwährend guten Halterung flächig anlegen kann.

Bis auf die oben erwähnte, hier nicht dargestellte Spitze des Körpers 13 sind sowohl der Körper 13 als auch das Hülsenelement 14 um eine Achse 19 rotationssymmetrisch, d.h. im wesentlichen zylindrisch ausgebildet. Dieses ist aber nicht in jedem Falle erforderlich, denn es sind auch andere Querschnittsformen sowohl des Hülsenelements 14 als auch des Körpers 13 grundsätzlich möglich.

Das hier vorgeschlagene Werkzeug 10 gestattet es auch, daß beispielsweise schon im Einsatz befindliche Werkzeuge 10, die bisher ein Hülsenelement 14 nicht aufwiesen und deshalb die eingangs genannten erheblichen Nachteile haben, derart modifiziert werden können, daß sie in bestehende Halter 11 von Bondvorrichtungen 12 eingesetzt werden können. Dazu wird beispielsweise der Körper 13 um einen bestimmten Betrag gekürzt und in ein vorbereitetes Hülsenelement 14 gemäß dem vorbeschriebenen Aufbau unter Ausbildung einer Klebeverbindung 16 zwischen Hülsenelement 14 und Körper 13 eingesetzt. Der Betrag der Länge, um die der Körper 13 gekürzt wird, ist derart bemessen, daß die Gesamtlänge aus Hülsenelement 14 und darin eingesetztem und verklebtem Körper 13 genauso groß ist wie zuvor die Gesamtlänge des Körpers 13 vor dem Kürzen. Das Hülsenelement 14 besteht hier beispielsweise aus Messing, das sich verhältnismäßig einfach und mit hoher Genauigkeit bearbeiten läßt, was eine Voraussetzung dafür ist, daß das Hülsenelement 14 und somit das gesamte Werkzeug 10 mit hoher Präzision sicher und dauerhaft fest im Halter 11 aufgenommen werden kann.

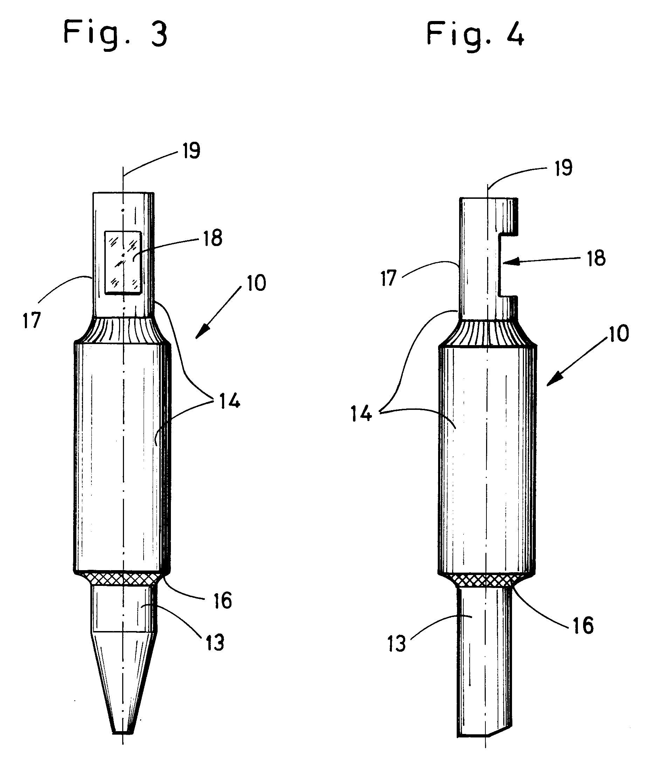

Die Figuren 3 und 4 zeigen ungeschnittene Seitenansichten des Werkzeugs 10, d.h. Fig. 4 eine um die Achse 19 um 90° gedrehte Ansicht des in Fig. 3 dargestellten Werkzeugs 10.

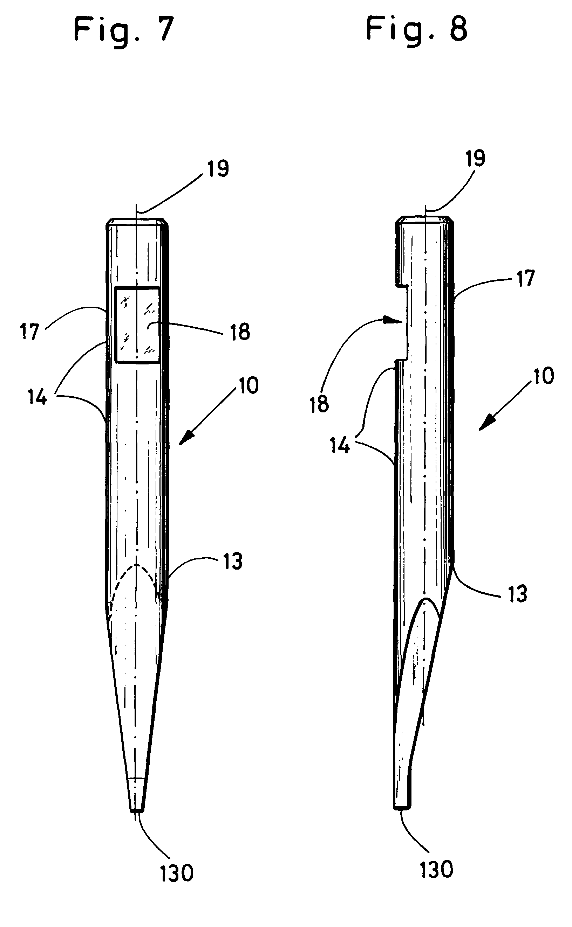

Die Figuren 5 und 6 sowie 7 und 8 zeigen ebenfalls ungeschnittene Seitenansichten des Werkzeugs 10, d. h. die Figuren 6 und 8 eine um die Achse 19 um 90° gedrehte Ansicht der in den Figuren 5 bzw. 7 dargestellten Werkzeuge 10. Die Werkzeuge gemäß den Figuren 5 bis 8 sind gegenüber den Werkzeugen in den Figuren 2 bis 4 modifiziert ausgebildet, d. h. das Hülsenelement 14 ist dort mit dem Körper 13 einstückig ausgebildet. Die Ausgestaltung des Werkzeugs 10 gemäß den Figuren 5 und 6 unterscheidet sich von der Ausgestaltung des Werkzeugs 10 gemäß den Figuren 7 und 8 auch noch dadurch, daß das Ende 17 bei der Ausgestaltung des Werkzeugs gemäß den Figuren 5 und 6 gegenüber dem übrigen Körper 13 in seinem Durchmesser vermindert bzw. verjüngt ausgebildet ist, wohingegen der Durchmesser des Werkzeugs gemäß den Figuren 7 und 8 an im Bereich des Endes 17 gleich groß ist wie der Durchmesser des übrigen Körpers 13.

Das Hülsenelement 14 kann auch mittels einer nach dem bekannten PVD-Verfahren (Physical Vapour Deposition) oder CVD-Verfahren (Chemical Vapour Deposition) und ihrer Verfahrensmodifikationen aufbringbaren Beschichtung des entsprechenden Teils des Halters 11 ausgebildet werden. Durch geeignete Verfahrensführung kann der Aufbau der Beschichtung in bezug auf ihre physikalischchemische Struktur und ihre mechanischen Eigenschften, d. h. Härte, Oberflächenstruktur, Elastizität, Wärmebeständigkeit usw., und ihre geometrische Struktur, d. h. Dicke der Beschichtung oder unterschiedliche Dicke der Beschichtung an unterschiedlichen Stellen des Hülsenelementes 14 bzw. des Halters 11, gezielt erfolgen.

Es ist aber auch möglich, lediglich die eigentliche Andruckspitze 130 des Körpers 13 mit einer Beschichtung im vorangehend beschriebenen Sinne zu versehen.

Die Beschichtung kann aus Metall oder Hartmetall oder Hartstoff, beispielsweise Titan, Titanlegierungen wie Titan-Hafnium oder Titan-Zirkonium oder aus Hartstoff bestehen. Als Hartstoffe eignen sich beispielsweise Titan-Nitrid oder Titancarbid oder Titan-Hafnium- bzw. Titan-Zirkonium-Nitrid bzw. Carbid. Die Beschichtung kann auch aus Carbiden und elementarem Kohlenstoff bzw. Kohlenstoffverbindungen und beispielsweise aus Diamant bestehen.

### Bezugszeichenliste

- 10: Werkzeug
- 11: Halter
- 12: Vorrichtung
- 13: Körper
- 130: Andruckspitze
- 14: Hülsenelement
- 15: Draht
- 16: Klebeverbindung
- 17: Ende
- 18: Spannfläche
- 19: Achse
- 20: Drahtklammer
- 21: Spannklammer
- 22: Drahtzuführung
- 23: Befestigungsmittel
- 24: Durchgangsloch

## Patentansprüche

1. Werkzeug zum Anbringen elektrischer Anschlußkontakte auf Halbleiterbauelementen oder zur Ausbildung elektrischer Verbindungen elektrischer Schaltkreise in Hybridschaltungen, umfassend einen in einem Halter einer Vorrichtung eingespannten stabförmigen, metallischen oder hartmetallischen oder aus Hartstoff bestehenden Körper, mit dem ein den Anschluß oder die Verbindung herstellender Draht auf eine Kontaktstelle des Bauelementes oder der Schaltung gepreßt wird, wobei nachfolgend mittels Schweißung der Draht mit der Kontaktstelle metallisch verbunden wird, dadurch gekennzeichnet, daß der Körper (13) wenigstens teilweise in einem Hülsenelement (14) haltend aufgenommen wird, wobei der Körper (13) über das Hülsenelement (14) im Halter (11) eingespannt wird.

2. Werkzeug nach Anspruch 1, dadurch gekennzeichnet, daß das Hülsenelement (14) aus einem metallischen oder hartmetallischen Werkstoff oder Hartstoff besteht.

3. Werkzeug nach Anspruch 2, dadurch gekennzeichnet, daß der metallische Werkstoff Messing ist.

4. Werkzeug nach einem oder mehreren der Ansprüche 1 bis 3, dadurch gekennzeichnet, daß der Körper (13) und das Hülsenelement (14) mittels einer Klebeverbindung (16) miteinander verbunden sind.

5. Werkzeug nach Anspruch 4, dadurch gekennzeichnet, daß die Klebeverbindung (16) mittels Epoxidharz ausgebildet wird.

6. Werkzeug nach einem oder mehreren der Ansprüche 1 bis 5, dadurch gekennzeichnet, daß das zum Halter (11) gerichtete Ende (17) des Hülsenelementes (14) verjüngt ausgebildet ist.

7. Werkzeug nach Anspruch 6, dadurch gekennzeichnet, daß das Hülsenelement (14) am verjüngten Ende (17) eine abgeplattete Spannfläche (18) aufweist.

8. Werkzeug nach einem oder mehreren der Ansprüche 1 bis 7, dadurch gekennzeichnet, daß das Hülsenelement (14) durch eine auf den Körper (13) auftragbare Beschichtung gebildet wird.

9. Werkzeug nach einem oder mehreren der Ansprüche 1 bis 3, 6 bis 8, dadurch gekennzeichnet, daß das Hülsenelement (14) und der Körper (13) einstückig ausgebildet sind.

10. Werkzeug nach einem oder mehreren der Ansprüche 1 bis 9, dadurch gekennzeichnet, daß wenigstens die Andruckspitze (130) des Körpers (13) mit einer Beschichtung versehen ist.

11. Werkzeug nach Anspruch 10, dadurch gekennzeichnet, daß die Beschichtung aus Metall, einer Metallegierung oder Hartmetall, aus einer Hartmetallegierung oder aus Hartstoff besteht.

12. Werkzeug nach Anspruch 10, dadurch gekennzeichnet, daß die Beschichtung aus Diamant besteht.
